# EUROPEAN PATENT APPLICATION

(11) **EP 4 852 414 A1**
(43) Date of publication of application: **09.12.2026**
(21) Application number: 25809943.1
(22) Date of filing: 14.04.2025
(51) Int. Cl.: H04M 1/02, H05K 5/03, H05K 5/02

(54) **ELECTRONIC DEVICE COMPRISING COMPOSITE TAPE**

(30) Priority: 09.05.2024 KR 20240061394; 23.07.2024 KR 20240097292
(71) Applicant: Samsung Electronics Co., Ltd., Suwon-si, Gyeonggi-do 16677 (KR)
(72) Inventor: MOON, Heecheul, Suwon-si, Gyeonggi-do 16677 (KR); LIM, Jinho, Suwon-si, Gyeonggi-do 16677 (KR); YOO, Minwoo, Suwon-si, Gyeonggi-do 16677 (KR)
(74) Representative: Nederlandsch Octrooibureau
(86) International application number: PCT/KR2025/005013
(87) International publication number: WO 2025/234630

(57) **Abstract**

According to various embodiments, an electronic device comprises a side frame, a first cover member coupled to the side frame, and a composite tape for attaching the first cover member to the side frame, wherein the composite tape includes: at least one first tape member made of a first material; and a second tape member, which is stacked on the at least one first tape member and is made of a stretchable second material, and at least a part of the composite tape can be arranged to be exposed through at least one opening formed at the first cover member in a state in which the first cover member is attached to the side frame through the composite tape.

## Description

### [Technical Field]

Embodiments of the disclosure relate to an electronic device including a composite tape.

### [Background Art]

An electronic device may include a side frame (e.g., a lateral member) and at least one cover that forms a housing (e.g., a housing structure) by being coupled to the side frame. The electronic device may include a plurality of electrical components in an internal space of the housing, and may have a sealed structure for protection from external moisture and/or foreign substances. Such a sealed structure may be achieved through a tape member that couples at least one cover member (e.g., the cover) to the side frame. The electronic device may require a separation structure that allows easy separation of the at least one cover from the side frame during maintenance.

The above information may be presented as related art only to assist with an understanding of the disclosure. No determination has been made, and no assertion is made, as to whether any of the above might be applicable as prior art with regard to the disclosure.

### [Disclosure of Invention]

### [Technical Problem]

An electronic device may include a housing (e.g., a housing structure) provided through a side frame (e.g., a lateral member or a lateral bezel structure) and at least one cover member (e.g., a cover) coupled to the side frame using a tape member (e.g., an adhesive tape, a waterproof tape, a double-sided tape, or an adhesive member). The electronic device may include a plurality of electrical components (e.g., a substrate, a battery, or various hardware components) disposed in an internal space of the housing. The plurality of electrical components may be protected from external moisture and/or foreign substances by being disposed in a sealed space of the housing formed by the side frame and the at least one cover member coupled to each other through the tape member. The tape member couples the side frame and the at least one cover member through an adhesive (e.g., an adhesive material) and, under normal conditions, may have strong adhesive strength such that the at least one cover member is not arbitrarily separated from the side frame.

For the electronic device, maintenance may be required to replace malfunctioning internal electrical components or to separate the at least one cover member from the side frame due to damage caused by an external impact.

However, due to the strong adhesive strength of the tape member, it may be difficult to separate the at least one cover member from the side frame. Furthermore, to reduce the strong adhesive strength of the tape member, a separation process may be difficult and maintenance costs may increase because specific equipment that generates high-temperature heat must be used.

Various embodiments of the disclosure may provide an electronic device including a composite tape configured to facilitate easy separation of at least one cover member from a side frame.

Various embodiments may provide an electronic device including a composite tape configured to facilitate easy separation of at least one cover member from a side frame through a simple manual operation of a user without separate disassembly equipment.

Various embodiments may provide an electronic device including a composite tape configured to facilitate easy separation of a cover member from a side frame through a relatively simple process and with low costs.

However, the technical problems to be solved by the disclosure are not limited to those mentioned above, and may be variously extended within the scope and spirit of the disclosure without departing therefrom.

### [Solution to Problem]

According to various embodiments, an electronic device may include a side frame, a first cover member coupled to the side frame, and a composite tape attaching the first cover member to the side frame. The composite tape may include at least one first tape member formed of a first material, and a second tape member laminated on the at least one first tape member and formed of a stretchable second material. In a state where the first cover member is attached to the side frame through the composite tape, at least a portion of the composite tape may be disposed to be exposed through at least one opening formed in the first cover member.

According to various embodiments, an electronic device may include a front cover, a rear cover disposed spaced apart from the front cover, a side frame disposed to surround a space between the front cover and the rear cover, a display disposed in the space and visible from the outside through at least a portion of the front cover, and a composite tape attaching the rear cover to the side frame. The composite tape may include at least one first tape member formed of a first material, and a second tape member laminated on the at least one first tape member and formed of a stretchable second material. In a state where the rear cover is attached to the side frame through the composite tape, at least a portion of the composite tape may be disposed to be exposed through at least one opening formed in the rear cover.

### [Advantageous Effects of Invention]

An electronic device according to exemplary embodiments of the disclosure may include a composite tape that includes a first tape member and a second tape member laminated on the first tape member and formed of a stretchable (e.g., elongatable) material, wherein at least a portion of the composite tape is operably exposed to the outside through at least one opening formed in a cover member. Accordingly, by simply pulling and stretching the exposed portion of the composite tape, the adhesive strength of the composite tape is weakened, thereby inducing easy separation of the cover member. In addition, since the cover member can be easily separated from a side frame through a simple manual operation of a user, a disassembly process for the cover member is simplified, and since separate equipment for disassembling the cover member is not required, it can help reduce maintenance costs.

In addition, various effects that are directly or indirectly understood through the present document may be provided.

The effects obtainable from the disclosure are not limited to those mentioned above, and other effects not mentioned herein will be clearly understood from the following description by a person skilled in the art to which the disclosure pertains.

### [Brief Description of Drawings]

With regard to the description of the drawings, the same or similar reference numerals may be used for the same or similar elements.
FIG. 1 is a perspective view of a front surface of an electronic device according to various embodiments of the disclosure.
FIG. 2 is a perspective view of a rear surface of the electronic device of FIG. 1 according to various embodiments of the disclosure.
FIG. 3A is an exploded perspective view of an electronic device according to various embodiments of the disclosure.
FIG. 3B is an exploded perspective view of a composite tape according to various embodiments of the disclosure.
FIG. 3C is a view illustrating a composite tape applied to a rear cover according to various embodiments of the disclosure.
FIG. 4A is a view illustrating a rear surface of an electronic device according to various embodiments of the disclosure.
FIG. 4B is a partial cross-sectional view of the electronic device taken along line 4b-4b of FIG. 4A according to various embodiments of the disclosure.
FIG. 5A is a view illustrating a state in which a side frame and a rear cover are attached through a composite tape according to various embodiments of the disclosure.
FIG. 5B is a view illustrating a state in which a composite tape is stretched according to various embodiments of the disclosure.
FIG. 6A is a view illustrating a state in which a side frame and a rear cover are attached through a composite tape according to various embodiments of the disclosure.
FIG. 6B is a view illustrating a state in which a composite tape is stretched according to various embodiments of the disclosure.
FIGS. 7A and 7B are views illustrating a process for separating a composite tape from an electronic device according to various embodiments of the disclosure.
FIG. 8A is an exploded perspective view of a composite tape according to various embodiments of the disclosure.
FIG. 8B is a partial cross-sectional view of an electronic device to which the composite tape of FIG. 8A is applied according to various embodiments of the disclosure.
FIG. 9A is an exploded perspective view of a composite tape according to various embodiments of the disclosure.
FIG. 9B is a view of a rear cover in which the composite tape of FIG. 9A is disposed according to various embodiments of the disclosure.
FIG. 10A is an exploded perspective view of a composite tape according to various embodiments of the disclosure.
FIG. 10B is a partial cross-sectional view of an electronic device to which the composite tape of FIG. 10A is applied according to various embodiments of the disclosure.
FIG. 11 is a partial cross-sectional view of an electronic device to which a composite tape is applied according to various embodiments of the disclosure.
FIG. 12A is a view illustrating a rear surface of an electronic device according to various embodiments of the disclosure.
FIG. 12B is a partial perspective view of an electronic device in a state where a composite tape is separated according to various embodiments of the disclosure.
FIG. 13A is a view of a rear cover to which a composite tape is applied according to various embodiments of the disclosure.
FIG. 13B is a partial cross-sectional view of the composite tape taken along line 13b-13b of FIG. 13A according to various embodiments of the disclosure.

### [Mode for the Invention]

Hereinafter, embodiments of the disclosure will be described in detail with reference to the accompanying drawings so that those of ordinary skill in the art to which the disclosure pertains can easily implement them. However, the disclosure may be implemented in various different forms and is not limited to the embodiments described herein. In connection with the description of the drawings, the same or similar reference numerals may be used for the same or similar elements. In addition, in the drawings and related descriptions, descriptions of well-known functions and configurations may be omitted for clarity and conciseness.

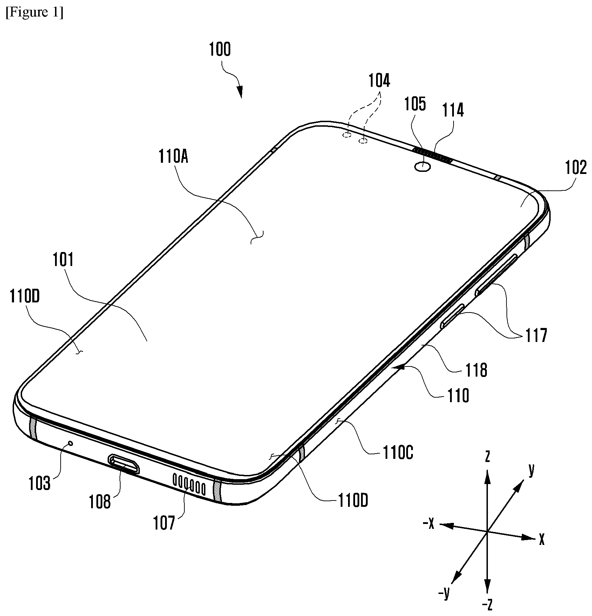

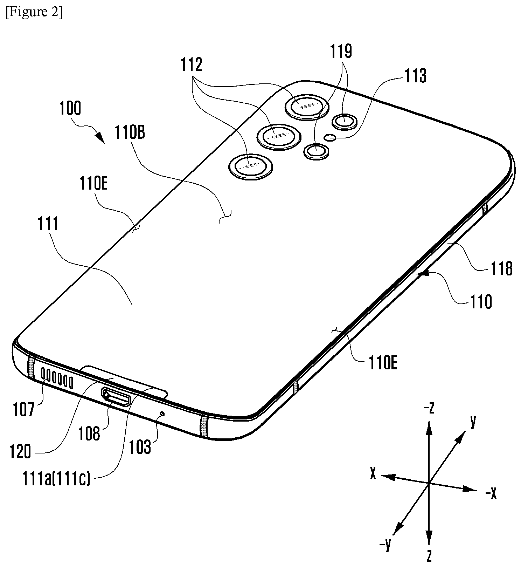

FIG. 1 is a perspective view of a front surface of an electronic device according to various embodiments of the disclosure. FIG. 2 is a perspective view of a rear surface of the electronic device of FIG. 1 according to various embodiments of the disclosure.

Referring to FIGS. 1 and 2, an electronic device 100 (e.g., a mobile electronic device or a portable communication device) may include a housing 110 (e.g., a housing structure) including a front surface (or a first surface) 110A, a rear surface (or a second surface) 110B, and a side surface 110C surrounding a space between the front surface 110A and the rear surface 110B. In another embodiment (not shown), the housing may refer to a structure that forms a part of the front surface 110A, the rear surface 110B, and the side surfaces 110C as shown in FIG. 1. According to an embodiment, at least a portion of the front surface 110A may be formed by a front cover 102 (e.g., a glass plate, a front plate, or a polymer plate including various coating layers) that is substantially transparent. The rear surface 110B may be formed by a rear cover 111 that is substantially opaque. The rear cover 111 (e.g., a rear plate) may be formed of, for example, coated or colored glass, ceramic, polymer, metal (e.g., aluminum, stainless steel (STS), or magnesium), or a combination of at least two of the above materials. The side surface 110C is coupled to the front cover 102 and the rear cover 111, and may be formed by a side frame 118 (e.g., a lateral bezel structure or a lateral member) including a metal and/or a polymer. In some embodiments, the rear cover 111 and the side frame 118 may be integrally formed and include the same material (e.g., a metallic material such as aluminum).

In the illustrated embodiment, the front cover 102 may include, at both long edges of the front cover 102, a first region 110D that is bent from the front surface 110A toward the rear cover 111 and seamlessly extends. In the illustrated embodiment (refer to FIG. 2), the rear cover 111 may include, at both long edges, a second region 110E that is bent from the rear surface 110B toward the front cover 102 and seamlessly extends. In some embodiments, the front cover 102 or the rear cover 111 may include only one of the first region 110D or the second region 110E. In some embodiments, the front cover 102 may not include the first region and the second region, and may include only a flat plane disposed parallel to the rear surface 110B. In the above embodiments, when viewed from the side surface of the electronic device 100, the side frame 118 may have a first thickness (or width) on a side surface where the first region 110D or the second region 110E is not included, and may have a second thickness that is smaller than the first thickness on a side surface where the first region 110D or the second region 110E is included.

According to various embodiments, the electronic device 100 may include at least one of a display 101, an input device 103, sound output devices 107 and 114, sensor modules 104 and 119, camera modules 105 and 112, a key input device 117, an indicator (not shown), and a connector 108. In some embodiments, the electronic device 100 may omit at least one (e.g., the key input device 117 or the indicator) of the above-mentioned elements, or may further include any other element.

The display 101 may be exposed through, for example, a substantial portion of the front cover 102. In some embodiments, at least a portion of the display 101 may be exposed through the front cover 102 forming the front surface 110A and the first region 110D of the side surface 110C. The display 101 may be combined with or disposed adjacent to a touch sensing circuit, a pressure sensor capable of measuring the intensity (pressure) of a touch, and/or a digitizer that detects a magnetic field-type stylus pen. In some embodiments, at least a portion of the sensor modules 104 and 119 and/or at least a portion of the key input device 117 may be disposed in the first region 110D and/or the second region 110E.

The input device 103 may include a microphone 103. In some embodiments, the input device 103 may include a plurality of microphones 103 arranged to detect the direction of sound. The sound output devices 107 and 114 may include speakers 107 and 114. The speakers 107 and 114 may include an external speaker 107 and a receiver for calls 114. In some embodiments, the microphone 103, the speakers 107 and 114, and the connector 108 may be at least partially disposed in the internal space of the electronic device 100, and may be exposed to the external environment through at least one hole formed in the housing 110. In some embodiments, the hole formed in the housing 110 may be commonly used for the microphone 103 and the speakers 107 and 114. In some embodiments, the sound output devices 107 and 114 may include a speaker (e.g., a piezo speaker) that operates without any hole formed in the housing 110.

The sensor modules 104 and 119 may generate an electrical signal or a data value corresponding to an internal operating state of the electronic device 100 or an external environmental state. The sensor modules 104 and 119 may include, for example, a first sensor module 104 (e.g., a proximity sensor) disposed on the front surface 110A of the housing 110, and/or a second sensor module (not shown) (e.g., a fingerprint sensor), and/or a third sensor module 119 (e.g., an HRM sensor) disposed on the rear surface 110B of the housing 110. The fingerprint sensor may be disposed on the front surface 110A (e.g., a home key button) of the housing 110, a partial region of the rear surface 110B, and/or under the display 101. The electronic device 100 may further include at least one of sensor modules not shown, for example, a gesture sensor, a gyro sensor, an atmospheric pressure sensor, a magnetic sensor, an acceleration sensor, a grip sensor, a color sensor, an infrared (IR) sensor, a biometric sensor, a temperature sensor, a humidity sensor, a proximity sensor, or an illuminance sensor.

The camera modules 105 and 112 may include a first camera module 105 disposed on the front surface 110A of the electronic device 100, and a second camera module 112 disposed on the rear surface 110B, and/or a flash 113. The camera modules 105 and 112 may include one or a plurality of lenses, an image sensor, and/or an image signal processor. The flash 113 may include, for example, a light emitting diode or a xenon lamp. In some embodiments, two or more lenses (a wide-angle lens, an ultra-wide-angle lens, or a telephoto lens) and image sensors may be disposed on one surface of the electronic device 100.

The key input device 117 may be disposed on the side surface 110C of the housing 110. In another embodiment, the electronic device 100 may not include some or all of the above-mentioned key input devices 117, and the key input device 117 not included may be implemented in another form, such as a soft key, on the display 101. In another embodiment, the key input device 117 may be implemented using a pressure sensor included in the display 101.

The indicator may be disposed, for example, on the front surface 110A of the housing 110. The indicator may provide, for example, status information of the electronic device 100 in the form of light (e.g., a light emitting element). In another embodiment, the light emitting element may provide, for example, a light source interlocked with the operation of the camera module 105. The indicator may include, for example, an LED, an IR LED, and/or a xenon lamp.

The connector hole 108 may include a first connector hole 108 capable of accommodating a connector (e.g., a universal serial bus (USB) connector) for transmitting and receiving power and/or data to and from an external electronic device, and/or a second connector hole (or an earphone jack) (not shown) capable of accommodating a connector for transmitting and receiving an audio signal to and from an external electronic device.

The camera module 105 among the camera modules 105 and 112, the sensor module 104 among the sensor modules 104 and 119, or the indicator may be disposed to be exposed through the display 101. For example, the camera module 105, the sensor module 104, or the indicator may be arranged in the internal space of the electronic device 100 to come into contact with the external environment through a through-hole perforated in the display 101 to the front cover 102. In another embodiment, the sensor module 104 may be arranged to perform its function without being visually exposed through the front cover 102 in the internal space of the electronic device. For example, a region of the display 101 facing the sensor module may not require a through-hole.

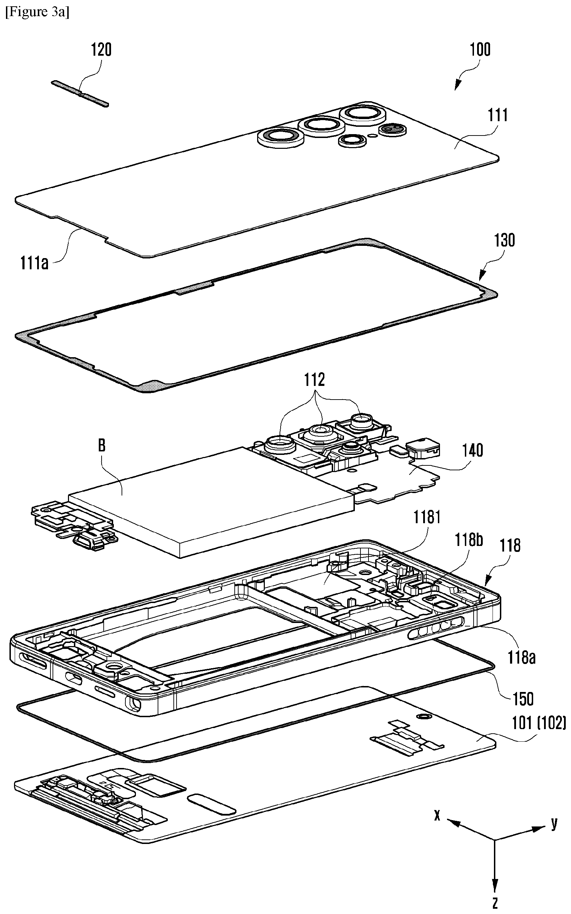

According to various embodiments, the electronic device 100 may include a composite tape (e.g., the composite tape 130 in FIG. 3A) disposed between the rear cover 111 and the side frame 118 to attach the rear cover 111 to the side frame 118, thereby providing a sealed internal space of the housing 110. In one embodiment, the sealed internal space of the housing 110 may provide a waterproof function and/or an antifouling function for protecting the aforementioned electrical components from external moisture and/or foreign substances.

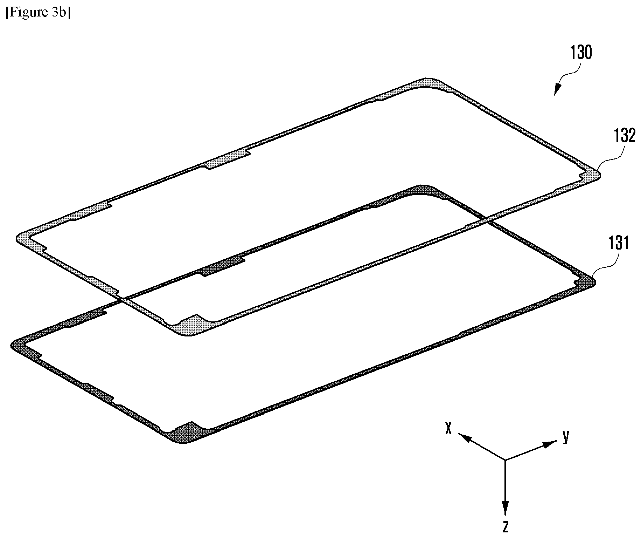

According to various embodiments, the electronic device 100 may include an opening 111c disposed in the rear surface 110B, and a finishing member 120 capable of filling at least a portion of the opening 111c by being accommodated in the at least a portion of the opening 111c. In one embodiment, the opening 111c may be formed through a notch 111a in which a portion of an edge of the rear cover is removed. In one embodiment, when maintenance is required for the electronic device 100, such as when replacement of the aforementioned electrical components disposed in the internal space of the housing 110 is required or replacement of the rear cover 111 is required, the finishing member 120 may be detached from the opening 111c. In one embodiment, at least a portion of the composite tape 130 may be visibly exposed to the outside through the opening 111c from which the finishing member 120 is detached. In one embodiment, the at least a portion of the composite tape 130 exposed through the opening 111c may be drawn out (e.g., pulled) to the outside by a user (an operator), and as the composite tape 130 including a stretchable tape member (e.g., the second tape member 132 in FIG. 3B) is stretched, adhesive strength thereof is weakened through a reduction in an adhesive area, thereby inducing easy separation of the rear cover 111 from the side frame 118.

FIG. 3A is an exploded perspective view of an electronic device according to various embodiments of the disclosure.

Referring to FIG. 3A, an electronic device 100 may include a side frame 118 (e.g., a lateral bezel structure or a lateral member), an extension member 1181 (e.g., a bracket, a support member, or a support structure), a front cover 102 (e.g., a front plate, a first plate, or a first cover), a display 101, at least one substrate 140 including a camera module 112, a battery B, and a rear cover 111 (e.g., a rear plate, a second plate, or a second cover). In some embodiments, the electronic device 100 may omit at least one of such elements or may additionally include any other element. At least one of the elements of the electronic device 100 may be the same as or similar to at least one of the elements of the electronic device 100 shown in FIG. 1 or 2, and redundant descriptions thereof will be omitted below.

According to various embodiments, the extension member 1181 may be disposed inside the electronic device 100 and connected to the side frame 118 or integrally formed with the side frame 118. The extension member 1181 may be formed of, for example, a metallic material and/or a non-metallic (e.g., polymer) material. The extension member 1181 may be coupled to the display 101 at a first surface 118a, and may be coupled to the at least one substrate 140 at a second surface 118b opposite to the first surface 118a. The electronic device 100 may include a processor, a memory, and/or an interface disposed on the at least one substrate 140. The processor may include, for example, one or more of a central processing unit (CPU), an application processor (AP), a graphics processing unit (GPU), an image signal processor (ISP), a sensor hub processor, or a communication processor (CP).

The memory may include, for example, a volatile memory or a non-volatile memory.

The interface may include, for example, a high-definition multimedia interface (HDMI), a universal serial bus (USB) interface, an SD card interface, and/or an audio interface. The interface may, for example, electrically or physically connect the electronic device 100 to an external electronic device, and may include a USB connector, an SD card/MMC connector, or an audio connector.

The battery B is a component for supplying power to at least one element of the electronic device 100, and may include, for example, a non-rechargeable primary battery, a rechargeable secondary battery, or a fuel cell. At least a portion of the battery B may be disposed substantially coplanar with the substrate 140, for example. The battery B may be disposed integrally with the electronic device 100 inside the electronic device 100. In another embodiment, the battery B may be detachably disposed from the electronic device 100.

According to various embodiments, the electronic device may include a waterproof tape (e.g., an adhesive member or a double-sided tape) disposed between the display and the first surface of the extension member. The waterproof tape may be disposed along a periphery between the rear surface of the display and the first surface, thereby providing a sealed space between the display and the first surface.

According to various embodiments, the electronic device 100 may include a composite tape 130 disposed between the rear cover 111 and the second surface 118b of the side frame 118. In one embodiment, the composite tape 130 may be disposed in a closed loop shape along a periphery between the second surface 118b of the extension member 1181 and the rear cover 111. In one embodiment, the aforementioned electrical components such as the substrate 140, the battery B, and the camera module 112 may be disposed in a sealed space between the rear cover 111 and the extension member 1181 through the composite tape 130, thereby being protected from external moisture and/or foreign substances.

According to exemplary embodiments of the disclosure, the electronic device 100 may include, in an assembled state, a separation structure that allows an easy separation of the rear cover 111 from the side frame 118 for maintenance. For example, the composite tape 130 may be disposed such that at least a portion thereof is visible from the outside or operably exposed through an opening (e.g., the opening 111c in FIG. 2) provided by a notch 111a formed in at least a portion of a periphery (e.g., an edge) of the rear cover 111.

According to various embodiments, the composite tape 130 may include at least one first tape member (e.g., the first tape member 131 in FIG. 3B) and a second tape member (e.g., the second tape member 132 in FIG. 3B) laminated on the first tape member 131 and formed of a stretchable material. Therefore, when the composite tape 130 exposed through the opening 111c is pulled outward by a user (e.g., an operator), it is stretched in a manner that an adhesive area thereof is reduced, and through the reduction in the adhesive area, it can help easily separate the rear cover from the side frame. In one embodiment, the opening 111c may be covered with a finishing member (e.g., a decorative member or a deco) detachably disposed to prevent external moisture and/or foreign substances from entering and to form an aesthetic appearance.

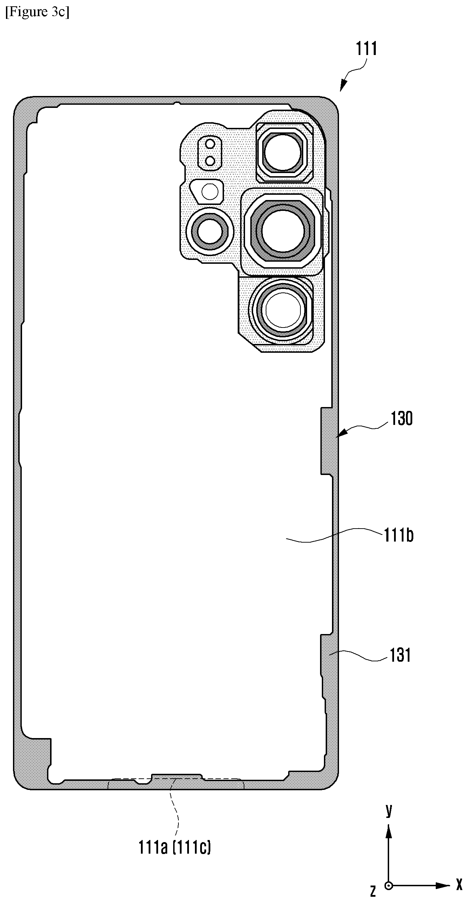

FIG. 3B is an exploded perspective view of a composite tape according to various embodiments of the disclosure. FIG. 3C is a view illustrating a composite tape applied to a rear cover according to various embodiments of the disclosure.

Referring to FIGS. 3B and 3C, the composite tape 130 may include a first tape member 131 and a second tape member 132 laminated on the first tape member 131. In one embodiment, the first tape member 131 may include a cushion layer (foam). In another embodiment, the first tape member 131 may include a substrate layer (e.g., polyethylene terephthalate (PET) or polyurethane (PU)) laminated on the cushion layer. In one embodiment, the second tape member 132 may be formed of a stretchable material. In one embodiment, the second tape member 132 may be formed of an elastic material such as silicone, rubber, or urethane. In one embodiment, the first tape member 131 and the second tape member 132 may be laminated in such a manner as to be attached to each other through an adhesive (e.g., a pressure-sensitive adhesive (PSA)) and/or a double-sided tape. In another embodiment, the first tape member 131 may be formed of a stretchable material.

According to various embodiments, the composite tape 130 may be disposed in a closed loop shape along a periphery on an inner surface 111b of the rear cover 111. In one embodiment, the composite tape 130 may be disposed to have different widths at least for each region along the periphery of the inner surface 111b of the rear cover 111. This is because enhanced waterproof and/or antifouling performance is required for each region. In another embodiment, the composite tape 130 may be formed to have a uniform width.

According to various embodiments, the rear cover 111 may include a notch 111a (e.g., a recess) recessed inward from at least a portion of the periphery. In some embodiments, the notch 111a may be replaced with an opening (e.g., an aperture) formed in at least a partial region of the rear cover 111, rather than the periphery thereof. In one embodiment, when the rear cover 111 is attached to a side frame (e.g., the side frame 118 in FIG. 3A) through the composite tape 130, the notch 111a may function as an opening 111c through which the composite tape 130 is visible from the outside. Therefore, in an upward view of the inner surface 111b of the rear cover 111, at least a portion of the composite tape 130 may be disposed to overlap at least a portion of the notch 111a. As illustrated, one notch 111a is formed at a lower periphery of the rear cover 111, but the disclosure is not limited thereto. For example, the rear cover 111 may further include at least one notch disposed at different locations (e.g., preferably in directions opposite to each other) in preparation for a case where the composite tape 130 is broken while being drawn out due to being excessively pulled. For example, the notch 111a may be formed at both the lower periphery and an upper periphery of the rear cover 111. In another embodiment, at least one notch 111a may be formed at each periphery of the rear cover 111.

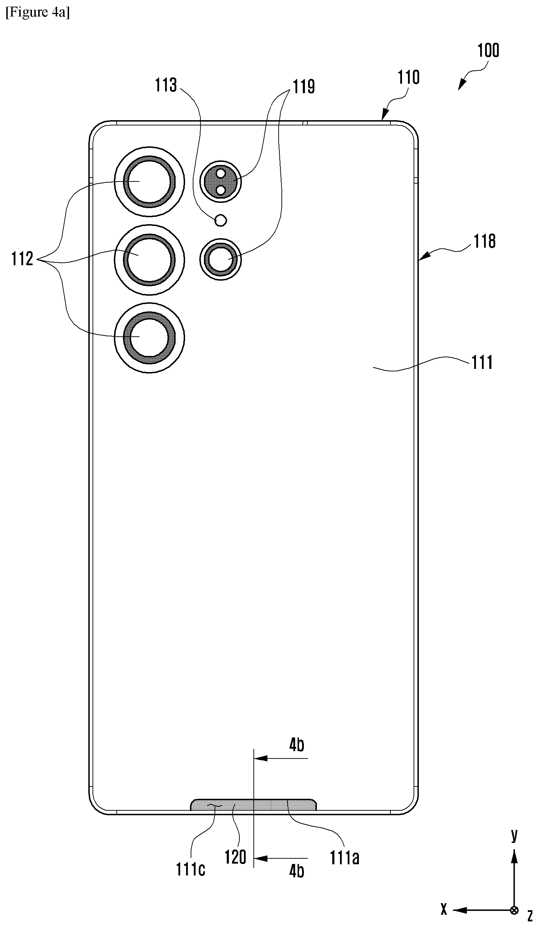

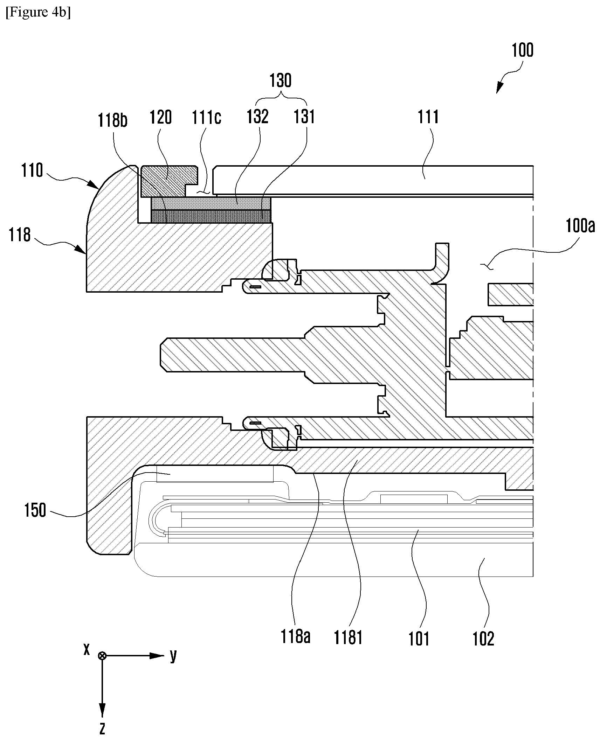

FIG. 4A is a view illustrating a rear surface of an electronic device according to various embodiments of the disclosure. FIG. 4B is a partial cross-sectional view of the electronic device taken along line 4b-4b of FIG. 4A according to various embodiments of the disclosure.

Referring to FIGS. 4A and 4B, an electronic device 100 may include a side frame 118 forming at least a portion of a side surface (e.g., the side surface 110C in FIG. 1). In one embodiment, the side frame 118 may include an extension member 1181 extending from the side surface 110C of the electronic device 100 into an internal space 100a and including a first surface 118a and a second surface 118b facing in a direction opposite to the first surface 118a. In one embodiment, the electronic device 100 may include a front cover 102 disposed on the first surface 118a of the extension member 1181. In one embodiment, the electronic device 100 may include a display 101 disposed in the internal space 100a to be visible from the outside through at least a portion of the front cover 102. In one embodiment, the display 101 may be attached to the first surface 118a of the extension member 1181 through a waterproof tape 150. In another embodiment, the waterproof tape 150 may be disposed between the front cover 102 and the first surface 118a of the extension member 1181. In one embodiment, the electronic device 100 may include a rear cover 111 disposed on the second surface 118b of the extension member 1181. In one embodiment, the rear cover 111 may be attached to the second surface 118b of the extension member 1181 through a composite tape 130.

According to various embodiments, the composite tape 130 may be visibly exposed to the outside through an opening 111c formed by a notch 111a disposed in at least a portion of a periphery of the rear cover 111. In one embodiment, the opening 111c may be covered with a finishing member 120 (e.g., a decorative member) so that the composite tape 130 is not visible from the outside after assembly is completed, thereby providing an aesthetic appearance of the electronic device 100.

According to various embodiments, the composite tape 130 may include a first tape member 131 and a stretchable second tape member 132 laminated on the first tape member 131. In one embodiment, the first tape member 131 may be disposed to face the second surface 118b of the extension member 1181. In one embodiment, the second tape member 132 may be disposed between the first tape member 131 and the rear cover 111 to face the rear cover 111. Therefore, when the composite tape 130 is disposed, the second tape member 132 may be exposed through the opening 111c. In another embodiment, the composite tape 130 may be disposed such that the first tape member 131 is exposed through the opening 111c.

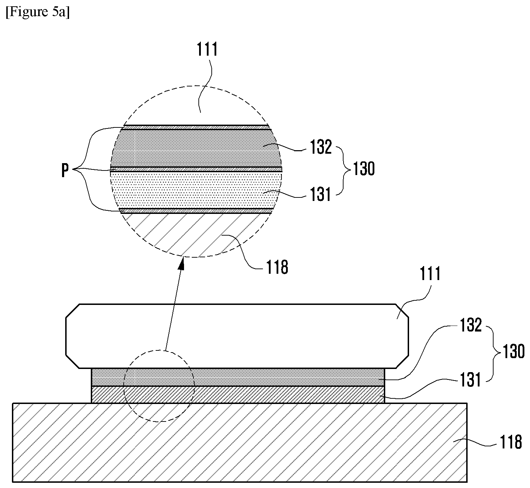

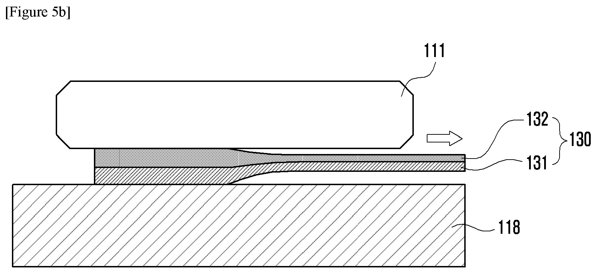

FIG. 5A is a view illustrating a state in which a side frame and a rear cover are attached through a composite tape according to various embodiments of the disclosure. FIG. 5B is a view illustrating a state in which a composite tape is stretched according to various embodiments of the disclosure.

Referring to FIGS. 5A and 5B, a composite tape 130 may include a first tape member 131 facing a side frame 118 and a second tape member 132 laminated on the first tape member 131 and facing a rear cover 111. In one embodiment, the first tape member 131 may include a cushion layer (e.g., foam). In one embodiment, the second tape member 132 may be formed of an elastic material such as rubber, silicone, or urethane. In one embodiment, the first tape member 131 and the second tape member 132 may be attached to each other through an adhesive P (e.g., PSA). In one embodiment, the composite tape 130 may be attached to the rear cover 111 and the side frame 118 through the adhesive P (e.g., PSA).

According to various embodiments, in a state where the rear cover 111 and the side frame 118 are attached, when the composite tape 130 is pulled in an outward direction (e.g., a direction indicated by an arrow) through an opening (e.g., the opening 111c in FIG. 4B), the first tape member 131 may also be pulled together through the stretching (elongation phenomenon) of the second tape member 132. Through the stretching of the composite tape 130, an adhesive area between the composite tape 130 and the rear cover 111 and an adhesive area between the composite tape and the side frame are reduced, thereby helping easily separate the rear cover 111 from the side frame 118. For example, when the composite tape is pulled, the adhesive area may be reduced in a direction perpendicular to the pulling direction.

In another embodiment, an adhesive strength (e.g., adhesive force) between the first tape member 131 and the second tape member 132 of the composite tape 130 may be set to be greater than an adhesive strength between the first tape member 131 and the side frame 118 and/or an adhesive strength between the second tape member 132 and the rear cover 111, thereby helping easily separate the rear cover 111.

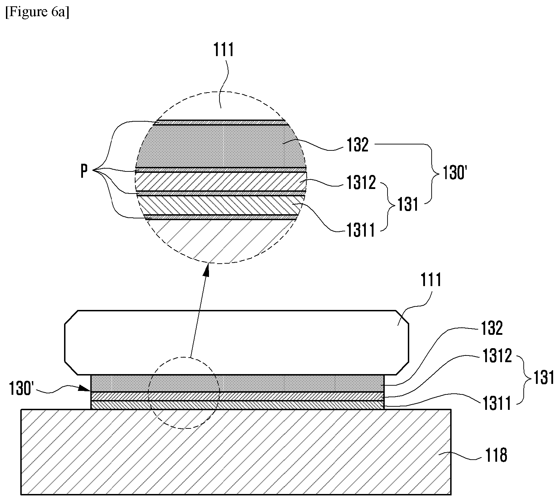

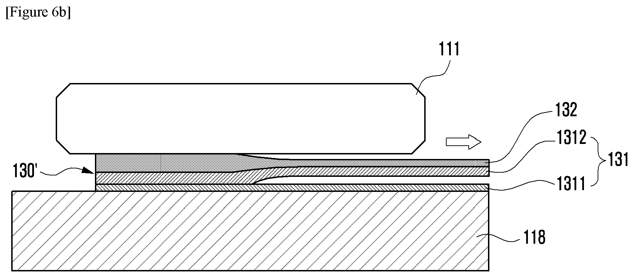

FIG. 6A is a view illustrating a state in which a space between a side frame and a rear cover is attached through a composite tape according to various embodiments of the disclosure. FIG. 6B is a state diagram illustrating a state in which a composite tape is stretched according to various embodiments of the disclosure.

Referring to FIGS. 6A and 6B, a composite tape 130 may include a first tape member 131 facing a side frame 118 and a second tape member 132 laminated on the first tape member 131 and facing a rear cover 111. In one embodiment, the first tape member 131 may include a cushion layer 1311 (e.g., foam) as a base layer. In one embodiment, the composite tape 130 may include a substrate layer 1312 (e.g., PET or PU) as an additional layer laminated on the cushion layer 1311. In one embodiment, the cushion layer 1311 may perform a cushioning function for the composite tape 130. In one embodiment, the substrate layer 1312 may be used for self-supporting of the first tape member 131. In one embodiment, the substrate layer 1312 may provide rigidity to the first tape member 131 and/or the composite tape 130 (by making them relatively less bendable), thereby helping improve productivity. In one embodiment, the first tape member 131 and the second tape member 132 may be attached to each other through an adhesive P (e.g., pressure sensitive adhesive (PSA)). In one embodiment, the composite tape 130 may be attached to the rear cover 111 and the side frame 118 through the adhesive P (e.g., PSA).

According to various embodiments, in a state where the rear cover 111 and the side frame 118 are attached, when the composite tape 130 is pulled in an outward direction (e.g., a direction indicated by an arrow) through an opening (e.g., the opening 111c in FIG. 4B), the substrate layer 1312 of the first tape member 131 may also be pulled together through the stretching (elongation phenomenon) of the second tape member 132. In this case, the cushion layer 1311 may be left on the side frame 118. In another embodiment, when the composite tape 130 is pulled, the cushion layer 1311 may also be pulled together while being attached to the rear cover 111. In one embodiment, through the stretching of the composite tape 130, an adhesive area between the composite tape 130 and the rear cover 111 and an adhesive area between the composite tape 130 and the side frame 118 are reduced, thereby helping easily separate the rear cover 111 from the side frame 118. For example, when the composite tape 130 is pulled, the adhesive area may be reduced in a direction perpendicular to the pulling direction.

In another embodiment, the adhesive strength (e.g., adhesive force) between the first tape member 131 and the second tape member 132 of the composite tape 130 may be set to be greater than the adhesive strength between the first tape member 131 and the side frame 118 and/or the adhesive strength between the second tape member 132 and the rear cover 111, thereby helping easily separate the rear cover 111.

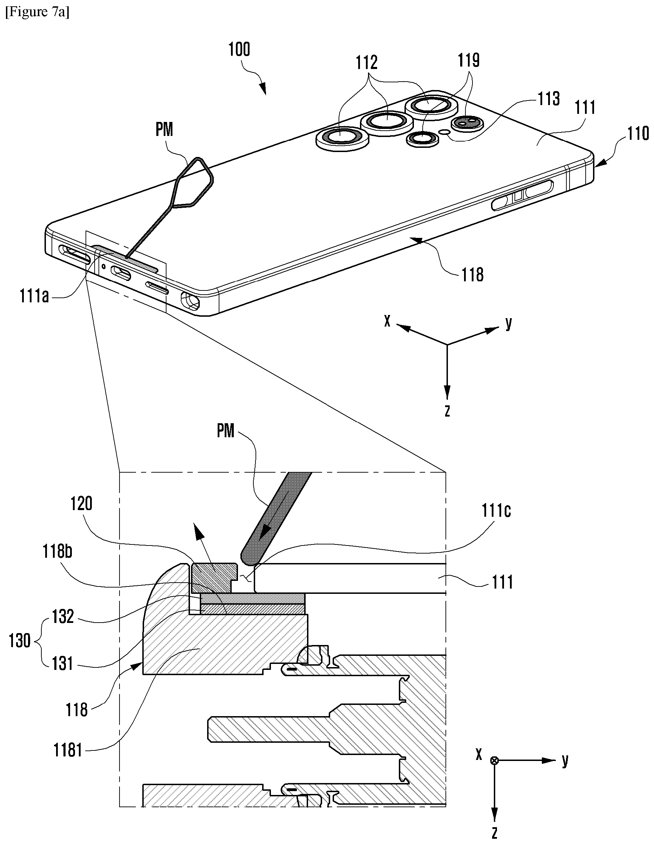

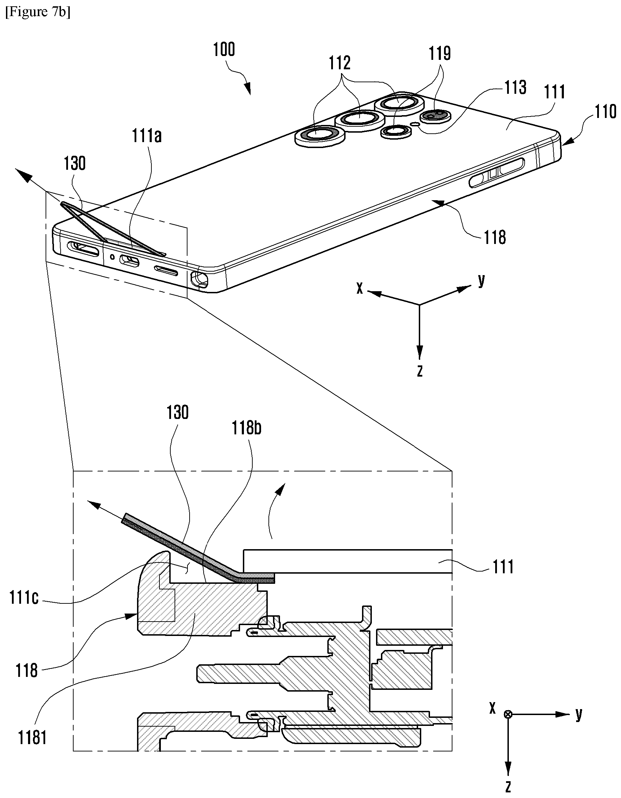

FIGS. 7A and 7B are views illustrating a process for separating a composite tape from an electronic device according to various embodiments of the disclosure.

In describing an electronic device 100 of FIGS. 7A and 7B, the same reference numerals are assigned to elements that are substantially the same as those of the electronic device 100 of FIG. 4B, and detailed descriptions thereof may be omitted.

Referring to FIGS. 7A and 7B, the electronic device 100 may include a side frame 118, a display 101 disposed on a first surface 118a of the side frame 118, and a rear cover 111 disposed on a second surface 118b of the side frame 118. In one embodiment, the rear cover 111 may be attached to the side frame 118 through a composite tape 130 disposed between the rear cover 111 and the second surface 118b along a periphery thereof. In one embodiment, the composite tape 130 may be disposed to be at least partially exposed through an opening 111c formed by a notch 111a of the rear cover 111. In one embodiment, the exposed composite tape 130 may be disposed so as to be invisible from the outside, as a finishing member 120 (e.g., a decorative member) at least partially fills the opening 111c. In one embodiment, the finishing member 120 may be formed of a rigid material (e.g., PC or metal) or an elastic material (rubber, silicone, or urethane), and may be prevented from being arbitrarily detached by being accommodated in the opening 111c in a manner such as interference fitting or taping.

According to various embodiments, when maintenance is required, such as when replacement of electrical components disposed in the internal space of the housing 110 is required or replacement of the rear cover 111 is required, the finishing member 120 may be removed from the opening 111c. For example, the finishing member 120 may be easily detached using a simple tool having a sharp end (e.g., a needle, a pin, or the like), or may be simply detached using a user's fingernail or the like. In one embodiment, at least a portion of the composite tape 130 may be visibly exposed to the outside through the opening 111c from which the finishing member 120 is removed. In one embodiment, at least a portion of the composite tape 130 exposed through the opening 111c may be drawn out (e.g., pulled) to the outside by a user (an operator), and as the composite tape 130 including a stretchable tape member 132 is stretched, an adhesive area with the rear cover 111 and the side frame 118 is reduced, thereby inducing easy separation of the rear cover 111 from the side frame 118.

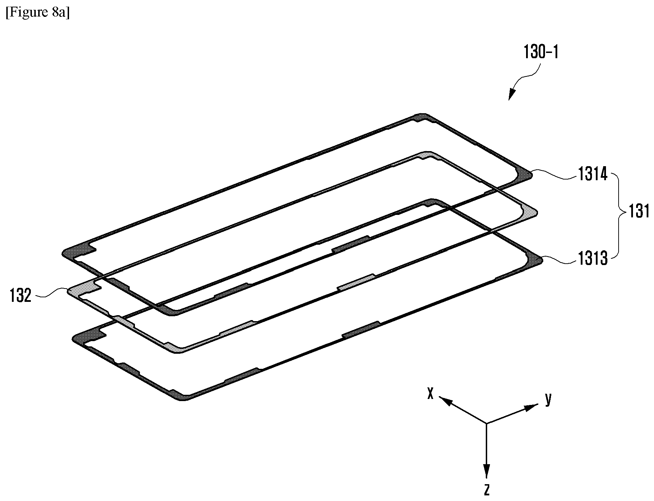

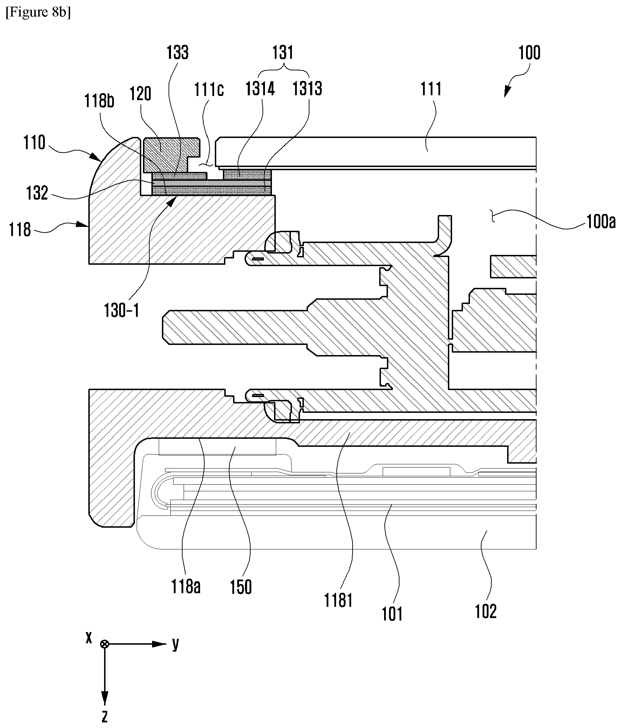

FIG. 8A is an exploded perspective view of a composite tape according to various embodiments of the disclosure. FIG. 8B is a partial cross-sectional view of an electronic device to which the composite tape of FIG. 8A is applied according to various embodiments of the disclosure.

In describing a composite tape 130-1 and an electronic device 100 of FIGS. 8A and 8B, the same reference numerals are assigned to elements that are substantially the same as those of the composite tape 130 and the electronic device 100 of FIG. 4B, and detailed descriptions thereof may be omitted.

Referring to FIGS. 8A and 8B, the composite tape 130-1 may include a first tape member 131 and a second tape member 132 laminated on the first tape member 131. In one embodiment, the second tape member 132 may be formed of a stretchable material, as described above. In one embodiment, the first tape member 131 may include a first sub-tape 1313 and a second sub-tape 1314. In one embodiment, the composite tape 130-1 may be configured in such a manner that the second tape member 132 is disposed between the first sub-tape 1313 and the second sub-tape 1314. In another embodiment, the second tape member 132 may be disposed between the first sub-tape 1313 and the side frame 118 or between the second sub-tape 1314 and the rear cover 111. In this case, the first sub-tape 1313 and the second sub-tape 1314 may be directly laminated. In one embodiment, each of the first sub-tape 1313 and the second sub-tape 1314 may have substantially the same self-lamination structure as the first tape member 131 of FIG. 5A or the first tape member 131 of FIG. 6A described above.

According to various embodiments, when the rear cover 111 is attached to the side frame 118 through the composite tape 130-1, the second tape member 132 may be disposed to be at least partially exposed through the opening 111c formed in the rear cover 111. In one embodiment, the opening 111c may be hidden through the finishing member 120 so as to be invisible from the outside. In this case, the finishing member 120 may be disposed in a manner of being attached to an additional tape 133 (e.g., a double-sided tape) laminated on the second tape member 132 exposed through the opening 111c.

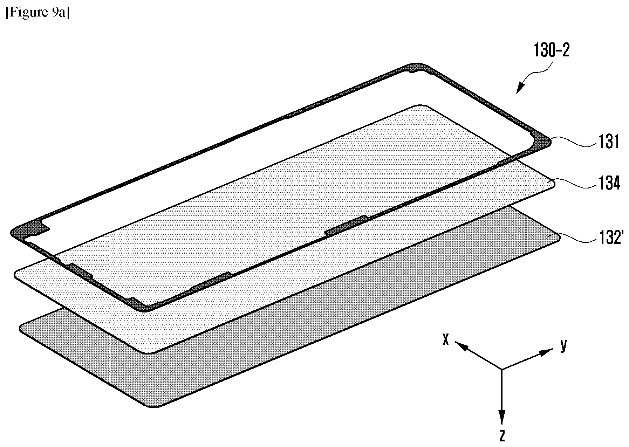

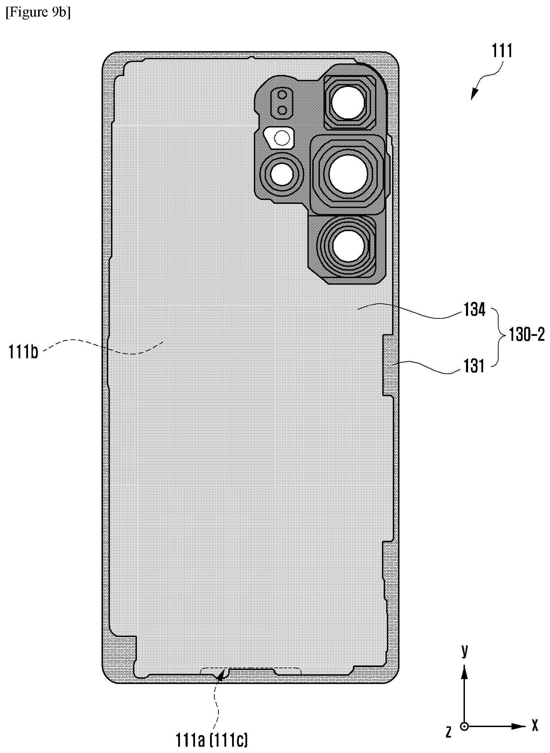

FIG. 9A is an exploded perspective view of a composite tape according to various embodiments of the disclosure. FIG. 9B is a view of a rear cover in which the composite tape of FIG. 9A is disposed according to various embodiments of the disclosure.

In describing a composite tape 130-2 of FIGS. 9A and 9B, the same reference numerals are assigned to elements that are substantially the same as those of the composite tape 130 of FIG. 4B, and detailed descriptions thereof may be omitted.

Referring to FIGS. 9A and 9B, the composite tape 130-2 may include a first tape member 131 and a second tape member 132' laminated on the first tape member 131. In one embodiment, the first tape member 131 may have substantially the same self-lamination structure as the first tape member 131 of FIG. 5A or the first tape member 131 of FIG. 6A described above. In one embodiment, the second tape member 132' may have a size corresponding to the entire area of the rear cover 111. For example, since a portion exposed through the opening 111c may be broken when pulled, the second tape member 132' is formed to have a relatively large area, thereby helping reduce a breakage phenomenon during drawing out. In this case, the composite tape 130-2 may include a single-sided tape 134 disposed between the first tape member 131 and the second tape member 132'. In one embodiment, the single-sided tape 134 has an adhesive layer formed only in a direction toward the rear cover 111 (e.g., a -z-axis direction), so that an unnecessary adhesive layer between structures and/or electrical components disposed in the internal space of the electronic device 100 may be excluded.

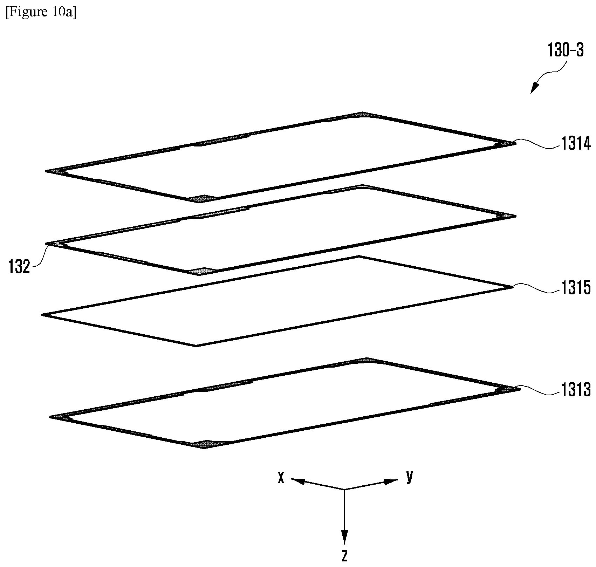

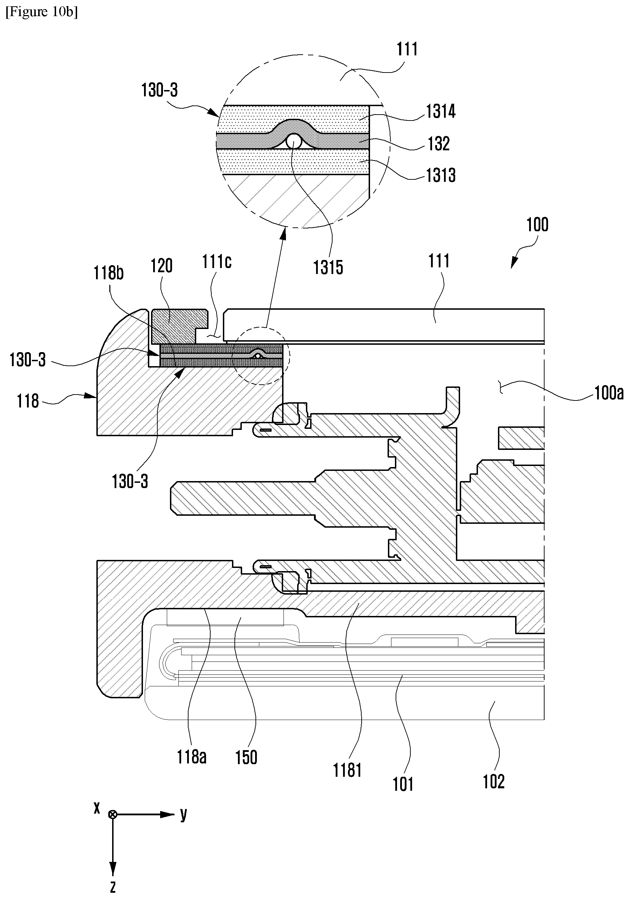

FIG. 10A is an exploded perspective view of a composite tape according to various embodiments of the disclosure. FIG. 10B is a partial cross-sectional view of an electronic device to which the composite tape of FIG. 10A is applied according to various embodiments of the disclosure.

In describing a composite tape 130-3 and an electronic device 100 of FIGS. 10A and 10B, the same reference numerals are assigned to elements that are substantially the same as those of the composite tape 130-1 and the electronic device 100 of FIGS. 8A and 8B, and detailed descriptions thereof may be omitted.

Referring to FIGS. 10A and 10B, the composite tape 130-3 may include a first sub-tape 1313, a second sub-tape 1314, and a second tape member 132 disposed between the first sub-tape 1313 and the second sub-tape 1314. In one embodiment, each of the first sub-tape 1313 and the second sub-tape 1314 may have substantially the same self-lamination structure as the first tape member 131 of FIG. 5A or the first tape member 131 of FIG. 6A described above. In one embodiment, the second tape member 132 may be formed of a stretchable material. In one embodiment, the composite tape 130-3 may include a string member 1315 (e.g., a wire member) disposed between the second tape member 132 and the first sub-tape 1313. In one embodiment, the string member 1315 may be disposed so as not to be exposed to the outside between the second tape member 132 and the first sub-tape 1313. In one embodiment, an adhesive strength between the second tape member 132 and the first sub-tape 1313 may be set to be relatively weak through the string member 1315, and this can help easily separate the rear cover 111 when the composite tape 130-3 is drawn out through the opening 111c. In one embodiment, the string member 1315 may be formed of a metal wire, a polymer, or a fiber material. In another embodiment, the string member 1315 may be disposed between the second tape member 132 and the second sub-tape 1314.

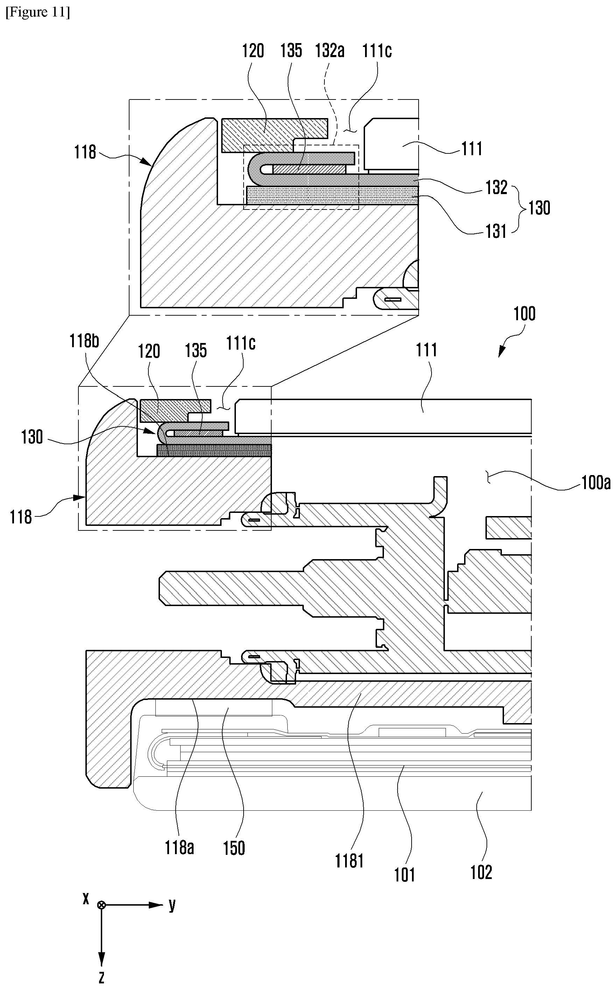

FIG. 11 is a partial cross-sectional view of an electronic device to which a composite tape is applied according to various embodiments of the disclosure.

In describing the arrangement structure of the composite tape 130 of FIG. 11, the same reference numerals are assigned to elements that are substantially the same as those of the arrangement structure of the composite tape 130 of FIG. 4B, and detailed descriptions thereof may be omitted.

Referring to FIG. 11, the composite tape 130 may include a first tape member 131 and a stretchable second tape member 132 laminated on the first tape member 131. In one embodiment, the first tape member 131 may be disposed to face a second surface 118b of an extension member 1181. In one embodiment, the second tape member 132 may be disposed between the first tape member 131 and a rear cover 111 so as to face the rear cover 111. Therefore, when the composite tape 130 is disposed, the second tape member 132 may be exposed through an opening 111c.

According to various embodiments, the composite tape 130 may include a folded region 132a (e.g., a bending region) exposed through the opening 111c and formed by the second tape member 132. In one embodiment, the folded region 132a may be a region where an end of the second tape member 132 is folded by 180 degrees to overlap itself. In one embodiment, the folded region 132a of the second tape member 132 may be configured to be separable through a release member 135 (e.g., a single-sided tape). Accordingly, when the second tape member 132 is drawn out through the opening 111c, a relatively long drawing-out length is secured, thereby helping easily draw out the composite member 130.

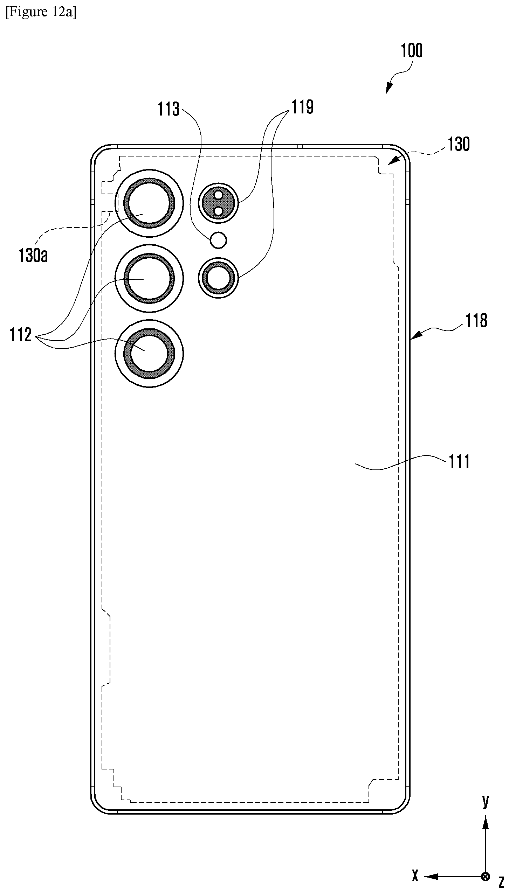

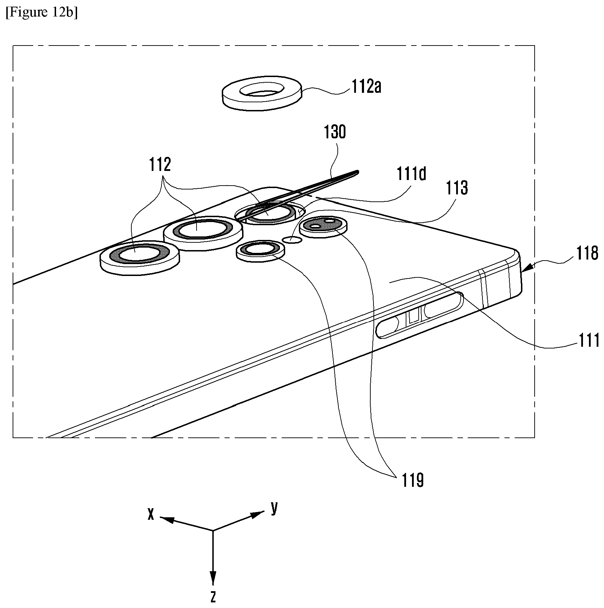

FIG. 12A is a view illustrating a rear surface of an electronic device according to various embodiments of the disclosure. FIG. 12B is a partial perspective view of an electronic device in a state where a composite tape is separated according to various embodiments of the disclosure.

According to various embodiments, even if the electronic device 100 has a configuration in which the opening 111c formed through a portion of the rear cover 111 is hidden through a finishing member 120 so that the composite tape 130 is invisible, the aesthetic appearance of the electronic device may be damaged by the finishing member 120.

Referring to FIGS. 12A and 12B, an opening 111d for drawing out the composite tape 130 may be disposed to be hidden by a decorative member 112a (e.g., a finishing member) disposed to at least surround a periphery of a camera module 112. For example, when the electronic device 100 is assembled, the opening 111d is hidden by the decorative member 112a for the camera module 112, so that the aforementioned separate finishing member 120 is unnecessary, and it can help form an aesthetic appearance of the electronic device 100. In this case, at least a portion of the composite tape 130 may include an extension 130a extending to a position overlapping the opening 111d when viewed from above the rear cover 111.

According to various embodiments, when maintenance is required for the electronic device 100, such as when replacement of electrical components disposed in the internal space of the housing 110 is required or replacement of the rear cover 111 is required, the decorative member 112a may be removed from the opening 111d disposed to surround the camera module 112. In one embodiment, at least a portion of the composite tape 130 may be visibly exposed to the outside through the opening 111d from which the decorative member 112a is removed. In one embodiment, at least a portion of the composite tape 130 exposed through the opening 111d may be drawn out (e.g., pulled) to the outside by a user (an operator), and as the composite tape 130 including a stretchable tape member (e.g., the second tape member 132 in FIG. 3B) is stretched, adhesive strength is weakened through a reduction in an adhesive area, thereby inducing easy separation of the rear cover 111 from the side frame 118.

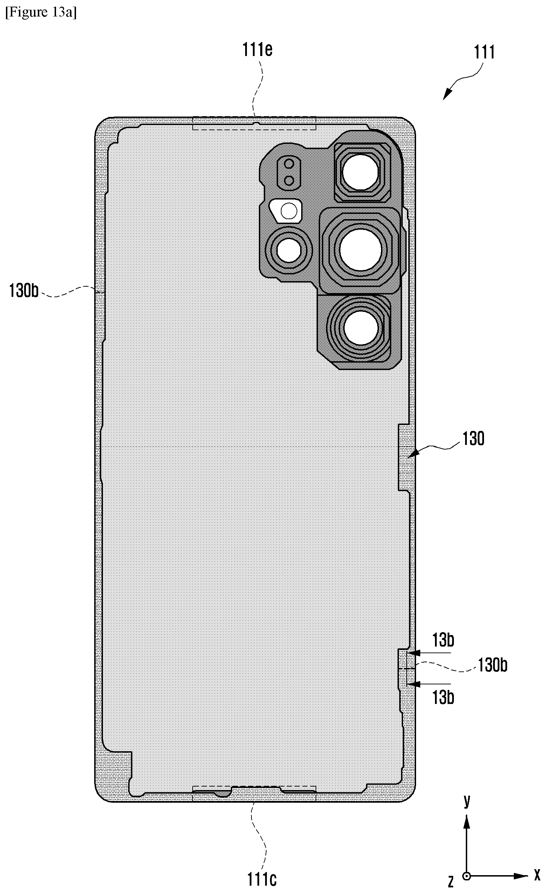

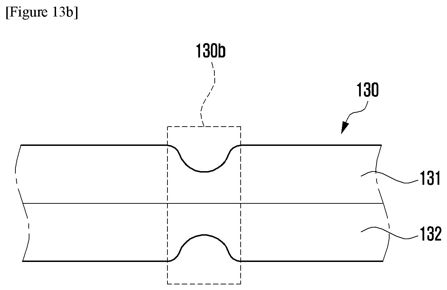

FIG. 13A is a view of a rear cover to which a composite tape is applied according to various embodiments of the disclosure. FIG. 13B is a partial cross-sectional view of the composite tape taken along line 13b-13b of FIG. 13A according to various embodiments of the disclosure.

Referring to FIGS. 13A and 13B, the composite tape 130 may be disposed in a closed-loop shape along a periphery of the rear cover 111. In this case, the composite tape 130 may include a breakage inducing region 130b formed in a specific area. In one embodiment, the breakage inducing region 130b may induce the composite tape 130 drawn out from a first opening 111c and a second opening 111e disposed at specific intervals in the rear cover 111 to be easily separated and drawn out through breakage. In one embodiment, the breakage inducing region 130b may include a region that is thinner than a peripheral portion of the first tape member 131 and/or the second tape member 132 of the composite tape 130. In another embodiment, the breakage inducing region 130b may include a cutout region formed at a specific depth in the corresponding region in the first tape member 131 and/or the second tape member 132 of the composite tape 130.

According to various embodiments, an electronic device includes a side frame (e.g., the side frame 118 in FIG. 4B), a first cover member (e.g., the rear cover 111 in FIG. 4B) coupled to the side frame, and a composite tape (e.g., the composite tape 130 in FIG. 4B) attaching the first cover member to the side frame. The composite tape includes at least one first tape member (e.g., the first tape member 131 in FIG. 4B) formed of a first material, and a second tape member (e.g., the second tape member 132 in FIG. 4B) laminated on the at least one first tape member and formed of a stretchable second material. In a state where the first cover member is attached to the side frame through the composite tape, at least a portion of the composite tape may be disposed to be exposed through at least one opening (e.g., the opening 111c in FIG. 4B) formed in the first cover member.

According to various embodiments, the at least one opening may be covered with a finishing member (e.g., the finishing member 120 in FIG. 4B).

According to various embodiments, the finishing member may be at least partially accommodated in the at least one opening.

According to various embodiments, the at least one opening may be formed through a notch (e.g., the notch 111a in FIG. 4A) recessed from a periphery of the first cover member.

According to various embodiments, the electronic device may further include at least one camera (e.g., the camera module 112 in FIG. 12B) disposed to be exposed from an internal space of the electronic device through the first cover member, and a finishing member (e.g., the decorative member 112a in FIG. 12B) disposed on the first cover member so as to surround the at least one camera, wherein the at least one opening (e.g., the opening 111d in FIG. 12B) may be provided through removal of the finishing member.

According to various embodiments, the composite tape may be disposed such that the second tape member is visible through the at least one opening.

According to various embodiments, the second material may include a material having a relatively greater stretchability than the first material.

According to various embodiments, the composite tape may be disposed along a periphery between the first cover member and the side frame.

According to various embodiments, the first tape member may include a first sub-tape (e.g., the first sub-tape 1313 in FIG. 8B) and a second sub-tape (e.g., the second sub-tape 1314 in FIG. 8B), and the second tape member may be disposed between the first sub-tape and the second sub-tape.

According to various embodiments, the electronic device may further include a string member (e.g., the string member 1315 in FIG. 10B) disposed between the at least one first tape member and the second tape member.

According to various embodiments, the first tape member may be disposed between the second tape member and the side frame, and the second tape member may be disposed between the first tape member and the first cover member.

According to various embodiments, an adhesive strength between the first tape member and the second tape member may be set to be greater than an adhesive strength between the first tape member and the side frame and/or than an adhesive strength between the second tape member and the first cover member.

According to various embodiments, the composite tape may be configured such that, when a portion thereof exposed through the at least one opening is pulled, the first tape member and the second tape member are stretched together.

According to various embodiments, the composite tape may include at least one breakage inducing region (e.g., the breakage inducing region 130b in FIG. 13A).

According to various embodiments, the side frame may include a side surface (e.g., the side surface 110C in FIG. 1A) exposed to the outside of the electronic device, and an extension member (e.g., the extension member 1181 in FIG. 4B) extending from the side surface into an internal space of the electronic device and including a first surface (e.g., the first surface 118a in FIG. 4B) and a second surface (e.g., the second surface 118b in FIG. 4B) opposite to the first surface, and the first cover member may be disposed so as to at least partially face the second surface of the extension member.

According to various embodiments, the electronic device may include a second cover member (e.g., the front cover 102 in FIG. 4B) disposed to at least partially face the first surface of the extension member, and a display (e.g., the display 101 in FIG. 4B) disposed in a space between the first surface and the second cover member, and disposed to be visible from the outside through the second cover member.

According to various embodiments, an electronic device may include a front cover (e.g., the front cover 102 in FIG. 4B), a rear cover (e.g., the rear cover 111 in FIG. 4B) disposed spaced apart from the front cover, a side frame (e.g., the side frame 118 in FIG. 4B) disposed to surround a space between the front cover and the rear cover, a display (e.g., the display 101 in FIG. 4B) disposed in the space and disposed to be visible from the outside through at least a portion of the front cover, and a composite tape (e.g., the composite tape 130 in FIG. 4B) attaching the rear cover to the side frame, wherein the composite tape includes at least one first tape member (e.g., the first tape member 131 in FIG. 4B) formed of a first material, and a second tape member (e.g., the second tape member 132 in FIG. 4B) laminated on the at least one first tape member and formed of a stretchable second material, and wherein in a state where the rear cover is attached to the side frame through the composite tape, at least a portion of the composite tape may be disposed to be exposed through at least one opening (e.g., the opening 111c in FIG. 4B) formed in at least a portion of the rear cover.

According to various embodiments, the at least one opening may be covered with a finishing member (e.g., the finishing member 120 in FIG. 4B).

According to various embodiments, the at least one opening may be formed through a notch (e.g., the notch 111a in FIG. 4A) recessed from a periphery of the first cover member.

According to various embodiments, the electronic device may include at least one camera (e.g., the camera module 112 in FIG. 12B) disposed to be exposed from the space through the rear cover, and a finishing member (e.g., the decorative member 112a in FIG. 12B) disposed on the rear cover to surround the at least one camera, wherein the at least one opening (e.g., the opening 111d in FIG. 4B) may be provided through removal of the finishing member.

The embodiments of the disclosure disclosed in the present specification and drawings are merely presented as specific examples to easily explain the technical contents according to the embodiments of the disclosure and to help the understanding of the embodiments of the disclosure, and are not intended to limit the scope of the embodiments of the disclosure. Therefore, the scope of various embodiments of the disclosure should be construed such that, in addition to the embodiments disclosed herein, all changes or modified forms derived based on the technical idea of various embodiments of the disclosure are included in the scope of various embodiments of the disclosure.

## Claims

1. An electronic device comprising:
a side frame (118);
a first cover member (111) coupled to the side frame; and
a composite tape (130) attaching the first cover member to the side frame,
wherein the composite tape includes:
at least one first tape member (131) formed of a first material; and
a second tape member (132) laminated on the at least one first tape member and formed of a stretchable second material, and
wherein, in a state where the first cover member is attached to the side frame through the composite tape, at least a portion of the composite tape is disposed to be exposed through at least one opening (111c) formed in the first cover member.

2. The electronic device of claim 1, wherein the at least one opening is covered with a finishing member (120).

3. The electronic device of claim 2, wherein the finishing member is at least partially accommodated in the at least one opening.

4. The electronic device of claim 1, wherein the at least one opening is formed through a notch (111a) recessed from a periphery of the first cover member.

5. The electronic device of claim 1, further comprising:
at least one camera (112) disposed to be exposed from an internal space of the electronic device through the first cover member; and
a finishing member (112a) disposed on the first cover member so as to surround the at least one camera,
wherein the at least one opening (111d) is provided through removal of the finishing member.

6. The electronic device of claim 1, wherein the composite tape is disposed such that the second tape member is visible through the at least one opening.

7. The electronic device of claim 1, wherein the second material includes a material having a relatively greater stretchability than the first material.

8. The electronic device of claim 1, wherein the composite tape is disposed along a periphery between the first cover member and the side frame.

9. The electronic device of claim 1, wherein the first tape member includes a first sub-tape (1313) and a second sub-tape (1314), and
wherein the second tape member is disposed between the first sub-tape and the second sub-tape.

10. The electronic device of claim 1, further comprising a string member (1315) disposed between the at least one first tape member and the second tape member.

11. The electronic device of claim 1, wherein the first tape member is disposed between the second tape member and the side frame, and
wherein the second tape member is disposed between the first tape member and the first cover member.

12. The electronic device of claim 11, wherein an adhesive strength between the first tape member and the second tape member is set to be greater than an adhesive strength between the first tape member and the side frame and/or than an adhesive strength between the second tape member and the first cover member.

13. The electronic device of claim 1, wherein the composite tape is configured such that, when a portion thereof exposed through the at least one opening is pulled, the first tape member and the second tape member are stretched together.

14. The electronic device of claim 1, wherein the composite tape includes at least one breakage inducing region (130b).

15. The electronic device of claim 14, wherein the side frame includes a side surface (110C) exposed to the outside of the electronic device, and an extension member (1181) extending from the side surface into an internal space of the electronic device and including a first surface (118a) and a second surface (118b) opposite to the first surface, and
wherein the first cover member is disposed so as to at least partially face the second surface of the extension member.
